# EUROPEAN PATENT APPLICATION

(11) **EP 4 832 055 A1**
(43) Date of publication of application: **28.10.2026**
(21) Application number: 25741746.9
(22) Date of filing: 08.01.2025
(51) Int. Cl.: H01L 21/677, B65G 47/80, B65G 47/84, B65G 47/90, H01L 21/52, H01L 21/67, H01L 21/68

(54) **CONVEYING DEVICE**

(30) Priority: 15.01.2024 JP 2024003906
(71) Applicant: Ueno Seiki Co., Ltd., Fukuoka 807-0052 (JP)
(72) Inventor: MASUDA, Takayuki, Onga-gun, Fukuoka 807-0052 (JP)
(74) Representative: LBP Lemcke, Brommer & Partner Patentanwälte mbB
(86) International application number: PCT/JP2025/000389
(87) International publication number: WO 2025/154613

(57) **Abstract**

Provided is a conveying device that efficiently and reliably conveys an electronic component. The conveying device includes a first rotary conveying section configured to move a first holding part that suction-holds an electronic component along a circular path, a second rotary conveying section configured to move a second holding part that suction-holds the electronic component along a circular path, and a position correction section provided between the first rotary conveying section and the second rotary conveying section on a conveyance path of the electronic component, and configured to correct a position of the electronic component received from the first holding part and transfer the electronic component to the second holding part. The position correction section includes a suction holding part that includes a suction surface configured to suction-hold the electronic component, and transfers the electronic component with the first holding part and the second holding part, a rotary conveying table that moves the suction holding part along a circular path, and a translational drive part that moves the rotary conveying table translationally and corrects a planar position of the electronic component suction-held by the suction holding part. The suction surface of the suction holding part and a suction surface of the second holding part facing each other at the second transfer position are parallel to each other.

## Description

### Technical Field

The present invention relates to a conveying device for an electronic component.

### Background Art

Electronic components such as semiconductor elements undergo processes such as visual inspection, electrical characteristic inspection, and marking treatment after manufacture, and are then shipped. In these processes, the electronic components need to be set in proper postures, and thus the postures of the electronic components are corrected before implementation of the processing of each process.

For example, Patent Document 1 discloses an electronic component processing device including a first rotary conveying section that includes a first holding part for holding an electronic component and is configured to move the first holding part along a first circular path, a second rotary conveying section that includes a second holding part for holding an electronic component and is configured to move the second holding part along a second circular path passing through a transfer region enabling transfer of the electronic component with the first holding part, and a position adjustment section that adjusts a position of the second holding part in the transfer region.

### Citation List

### Patent Literature

Patent Document 1: JP 2021-187598 A

### Summary of Invention

### Technical Problem

In the technology described in Patent Document 1 above, the second rotary conveying section moves the electronic component received from the first rotary conveying section to a position of an intermediate processing section that performs processing such as visual inspection, and then moves the electronic component processed by the intermediate processing section to a position of transfer to the first rotary conveying section. As a result, the position adjustment section cannot adjust the position of the second holding part while the intermediate processing section is implementing processing, making it necessary to separately secure time for implementation of alignment processing during transfer of the electronic component.

Further, the electronic component is conveyed by a holding part, such as a suction collet, for example, that suction-holds the electronic component on a suction surface. To stably convey the electronic component without dropping the electronic component, it is important that the electronic component is held without tilting relative to the suction surface of the holding part. For example, in the case of an electronic component having a relatively large size (having a length of a long side of about 5 to 10 mm, for example), tilting relative to the suction surface is unlikely to occur in the first place. However, in the case of an electronic component having a relatively small size (having a length of the long side of about 0.5 to 1 mm, for example), when the holding part picks up the electronic component to be conveyed from a wafer sheet, a bump (electrode) of the electronic component may enter a suction hole of the suction surface, causing the electronic component to be held on the suction surface in a tilted state.

The present invention has been made in view of the above problems, and an object of the present invention is to provide a conveying device of an electronic component that is capable of efficiently and reliably conveying the electronic component.

### Solution to Problem

To solve the problems described above, according to an aspect of the present invention, provided is a conveying device including a first rotary conveying section including a first holding part configured to suction-hold an electronic component on a suction surface of the first holding part, the first rotary conveying section configured to move the first holding part along a circular path, a second rotary conveying section including a second holding part configured to suction-hold the electronic component on a suction surface of the second holding part, the second rotary conveying section configured to move the second holding part along a circular path, and a position correction section provided between the first rotary conveying section and the second rotary conveying section on a conveyance path of the electronic component, the position correction section configured to correct a position of the electronic component received from the first holding part and transfer the electronic component to the second holding part. The position correction section includes a suction holding part that includes a suction surface configured to suction-hold the electronic component, transfers the electronic component with the first holding part at a first transfer position, and transfers the electronic component with the second holding part at a second transfer position, a rotary conveying table that is provided with the suction holding part, and moves the suction holding part along a circular path about a rotation axis, and a translational drive part that moves the rotary conveying table translationally, and corrects a planar position of the electronic component suction-held by the suction holding part. The suction surface of the suction holding part and the suction surface of the second holding part facing each other at the second transfer position are parallel to each other.

The rotary conveying table may intermittently move at a predetermined rotational pitch while stopping at the first transfer position and the second transfer position, and the translational drive part may move the rotary conveying table translationally during rotation of the rotary conveying table to correct the planar position of the electronic component suction-held by the suction holding part.

In the operation of the conveying device, a timing at which the electronic component is transferred from the first holding part to the suction holding part at the first transfer position may coincide with a timing at which the electronic component is transferred from the suction holding part to the second holding part at the second transfer position.

Alternatively, in the operation of the conveying device, a timing at which the electronic component is transferred from the first holding part to the suction holding part at the first transfer position may be different from a timing at which the electronic component is transferred from the suction holding part to the second holding part at the second transfer position.

### Advantageous Effects of Invention

As described above, according to the present invention, it is possible to efficiently and reliably convey an electronic component.

### Brief Description of Drawings

FIG. 1 is a schematic view illustrating a configuration of a conveying device according to an embodiment of the present invention, with an upper portion illustrating a plan view and a lower portion illustrating a side view.
FIG. 2 is a partial side view illustrating a state during transfer of an electronic component by a first holding part and a suction holding part.
FIG. 3 is a side view illustrating a configuration of a position correction section.
FIG. 4 is a timing chart illustrating operation of the conveying device in operation pattern 1.
FIG. 5 is a timing chart illustrating operation of the conveying device in operation pattern 2.
FIG. 6 is a schematic view illustrating a modification (first modification) of the configuration of the conveying device.
FIG. 7 is a schematic view illustrating a modification (second modification) of the configuration of the conveying device.
FIG. 8 is a schematic view illustrating a modification (third modification) of the configuration of the conveying device, and illustrates a case in which a suction surface of a second holding part and a suction surface of the suction holding part are parallel in a vertical direction.
FIG. 9 is a schematic view illustrating the modification (third modification) of the configuration of the conveying device, and illustrates a case in which the suction surface of the second holding part and the suction surface of the suction holding part are parallel in a horizontal direction.
FIG. 10 is a schematic view illustrating another modification of the configuration of the conveying device, and illustrates a case in which a position correction mechanism that corrects a planar position of the electronic component is provided in a second rotary conveying section.
FIG. 11 is a schematic view illustrating the second rotary conveying section and the position correction mechanism of the conveying device illustrated in FIG. 10, and illustrates the state illustrated in the upper portion of FIG. 10 as viewed from an X direction.

### Description of Embodiments

Hereinafter, a preferred embodiment of the present invention will be described in detail with reference to the accompanying drawings. Note that, in the present specification and the drawings, constituent elements having substantially the same functional configuration are denoted by the same reference numerals, and redundant description thereof will be omitted.

### 1. Conveying Device

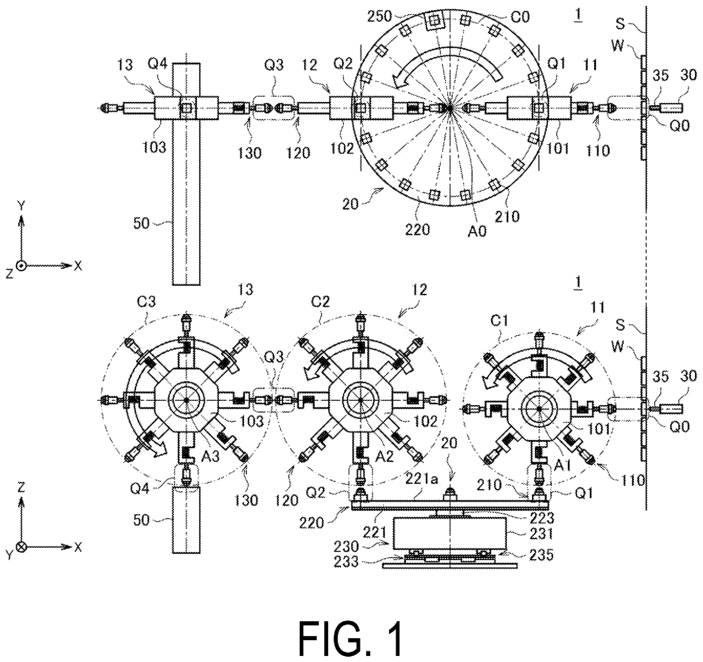

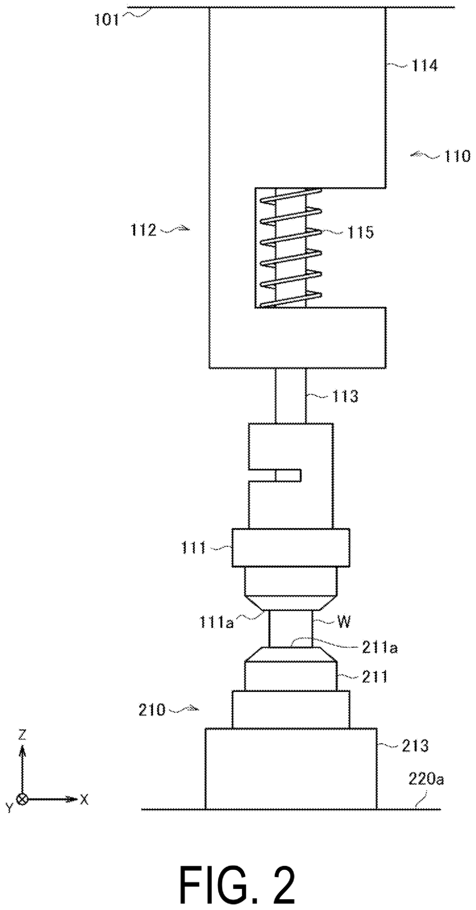

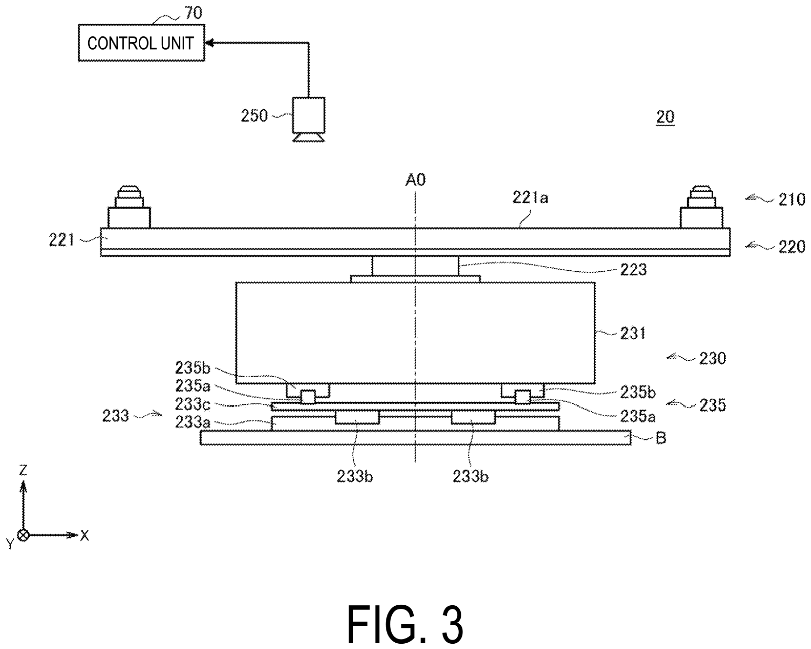

First, a configuration of a conveying device 1 according to an embodiment of the present invention will be described with reference to FIG. 1 to FIG. 3. FIG. 1 is a schematic view illustrating the configuration of the conveying device 1 according to the present embodiment, with an upper portion illustrating a plan view and a lower portion illustrating a side view. FIG. 2 is a partial side view illustrating a state during transfer of an electronic component W by a first holding part 110 and a suction holding part 210. FIG. 3 is a side view illustrating a configuration of a position correction section 20. In FIG. 1 to FIG. 3, an X direction and a Y direction are horizontal directions, and an XY plane is also referred to as a horizontal plane. A Z direction is a vertical direction orthogonal to the X direction and the Y direction. A ZX plane is also referred to as a vertical plane.

The conveying device 1 according to the present embodiment is a device that suction-holds the electronic components W one by one and conveys the electronic components W on a conveyance path. The electronic component W is a component used in an electrical product. For example, the electronic component W is a semiconductor element, a resistor, or a capacitor. The semiconductor element may be an integrated circuit such as an integrated circuit (IC) or a large scale integration (LSI), or may be a discrete semiconductor such as a transistor, a diode, a light-emitting diode (LED), a capacitor, or a thyristor.

As illustrated in FIG. 1, the conveying device 1 includes a first rotary conveying section 11, a second rotary conveying section 12, and the position correction section 20. The first rotary conveying section 11 and the second rotary conveying section 12 are arranged in parallel in the X direction as illustrated in the upper portion of FIG. 1, and rotate about rotation axes A1 and A2 parallel to the Y direction as illustrated in the lower portion of FIG. 1. As illustrated in the lower portion of FIG. 1, the position correction section 20 is provided between the first rotary conveying section 11 and the second rotary conveying section 12 on the conveyance path of the electronic components W, and rotates about a rotation axis A0 parallel to the Z direction.

### First Rotary Conveying Section

The first rotary conveying section 11 includes the first holding part 110 that suction-holds the electronic component W on a suction surface, and moves the first holding part 110 along a circular path C1. As illustrated in the lower portion of FIG. 1, the first rotary conveying section 11 includes a rotating body 101 that rotates about the rotation axis A1 parallel to the Y direction together with the rotation axis A1, and a plurality of the first holding parts 110 provided radially from the rotating body 101 in the ZX plane orthogonal to the Y direction.

The rotating body 101 is rotated by a drive part (not illustrated) such as a motor. The plurality of first holding parts 110 are provided on the rotating body 101 at predetermined intervals in a circumferential direction of an imaginary circle about the rotation axis A1. For example, in the first rotary conveying section 11 illustrated in FIG. 1, eight first holding parts 110 are provided on the rotating body 101 at equal intervals (that is, installation intervals of 45°). The drive part rotates and intermittently moves the rotating body 101 by the installation interval of the first holding parts 110. A rotation angle at which the rotating body 101 intermittently moves is defined as a rotational pitch of the first rotary conveying section 11.

As illustrated in FIG. 2, each of the first holding parts 110 includes a suction collet 111 and an advancing/retracting drive mechanism 112.

The suction collet 111 suction-holds the electronic component W at a suction surface 111a at a tip end. The suction collet 111 is a substantially conical member formed of, for example, rubber, resin, or metal. The suction surface 111a is a flat surface, and a suction hole (not illustrated) communicating with an internal passage of the first holding part 110 is formed in the surface. The internal passage of the first holding part 110 communicates with a pneumatic circuit of a negative pressure generation device such as a vacuum pump or an ejector. The negative pressure generation device generates negative pressure in the pneumatic circuit, making it possible for the suction collet 111 to hold the electronic component W on the suction surface 111a. Further, the negative pressure generation device releases a suction force from the negative pressure by vacuum breakage or atmospheric release, thereby causing the suction collet 111 to release the electronic component W held on the suction surface 111a.

The advancing/retracting drive mechanism 112 is a drive mechanism that moves the suction collet 111 in a radial direction of a circle about the rotation axis A1 (hereinafter also referred to as "advancing/retracting direction"). The advancing/retracting drive mechanism 112 includes a shaft 113, a connection member 114, and a coil spring 115.

The shaft 113 is a rod-shaped member extending in the advancing/retracting direction. The shaft 113 is connected to the rotating body 101 via the connection member 114 on the rotation axis A1 side (hereinafter, also referred to as "inner side"). Further, the shaft 113 includes the suction collet 111 at a tip end on a side opposite to the rotation axis A1 (hereinafter also referred to as "outer side"). The internal passage communicating with the suction hole of the suction collet 111 is formed in an interior of the shaft 113. The connection member 114 is a member for fixing the advancing/retracting drive mechanism 112 to the rotating body 101. A motor (not illustrated) for moving the shaft 113 in the advancing/retracting direction is provided in an interior of the connection member 114. In a state in which the shaft 113 is inserted into the interior, the coil spring 115 is fixed at an end portion on the inner side to the connection member 114, and fixed at an end portion on the outer side to an outer surface of the shaft 113.

Given a state in which a motor (not illustrated) of the advancing/retracting drive mechanism 112 is not being driven and the suction collet 111 is located at an innermost position as a reference, the advancing/retracting drive mechanism 112 drives the motor (not illustrated) to outward move the shaft 113 from the rotating body 101, thereby outward moving the suction collet 111. Further, the advancing/retracting drive mechanism 112 stops the driving of the motor (not illustrated), thereby inward moving the shaft 113, which had been moved outward, by a compression force of the coil spring 115 and moving the suction collet 111 to the reference position.

### Second Rotary Conveying Section

The second rotary conveying section 12 includes a second holding part 120 that suction-holds the electronic component W on a suction surface, and moves the second holding part 120 along a circular path C2. The second rotary conveying section 12 may have the same configuration as that of the first rotary conveying section 11.

As illustrated in the lower portion of FIG. 1, the second rotary conveying section 12 includes a rotating body 102 that rotates about the rotation axis A2 parallel to the Y direction together with the rotation axis A2, and a plurality of the second holding parts 120 provided radially from the rotating body 102 in the ZX plane orthogonal to the Y direction. The plurality of second holding parts 120 are provided on the rotating body 102 at predetermined intervals in a circumferential direction of an imaginary circle about the rotation axis A2. For example, in the second rotary conveying section 12 illustrated in FIG. 1, eight second holding parts 120 are provided on the rotating body 102 at equal intervals (that is, installation intervals of 45°). A drive part such as a motor that rotates the rotating body 102 intermittently moves the rotating body 102 by the installation interval of the second holding parts 120. A rotation angle at which the rotating body 102 intermittently moves is defined as a rotational pitch of the second rotary conveying section 12.

The second holding parts 120 are configured similarly to the first holding parts 110 illustrated in FIG. 2, and each includes a suction collet and an advancing/retracting drive mechanism. The second holding part 120 has the same configuration as that of the first holding part 110, and thus a detailed description thereof will be omitted here. The second holding part 120 moves the suction collet provided at a tip end in the advancing/retracting direction by an advancing/retracting movement mechanism.

### Position Correction Section

The position correction section 20 is provided between the first rotary conveying section 11 and the second rotary conveying section 12 on the conveyance path of the electronic component W, corrects the position of the electronic component W received from the first holding part 110, and transfers the electronic component W to the second holding part 120. As illustrated in FIG. 1 and FIG. 3, the position correction section 20 includes the suction holding part 210 that transfers the electronic component W with the first holding part 110 and the second holding part 120, a rotary conveying table 220, and a translational drive part 230 that moves the rotary conveying table 220 translationally.

The suction holding part 210 includes a suction surface 211a for suction-holding the electronic component W, and transfers the electronic component W with the first holding part 110 at a first transfer position Q1, and transfers the electronic component W with the second holding part 120 at a second transfer position Q2. As illustrated in the upper portion of FIG. 1, the suction holding parts 210 are provided at predetermined intervals in a circumferential direction of an imaginary circle about the rotation axis A0 parallel to the Z direction, on an upper surface 221a of a table 221 of the rotary conveying table 220 described below. For example, in the position correction section 20 illustrated in FIG. 1, 18 suction holding parts 210 are provided on the table 221 at equal intervals (that is, at installation intervals of 20°). The suction holding part 210 moves along a circular path C0 about the rotation axis A0 as the rotary conveying table 220 rotates.

The suction holding part 210 includes, for example, a suction collet 211 and a fixing member 213 as illustrated in FIG. 2.

The suction collet 211 suction-holds the electronic component W at the suction surface 211a at a tip end. The suction collet 211 may be the same as the suction collet 111 of the first holding part 110 and the suction collet of the second holding part 120. That is, the suction collet 211 is a substantially conical member formed of, for example, rubber, resin, or metal. The suction surface 211a is a flat surface. The suction collet 211 is provided such that the suction surface 211a is orthogonal to the rotation axis A0.

A suction hole (not illustrated) communicating with an internal passage of the suction holding part 210 is formed in the suction surface 211a. The internal passage of the suction holding part 210 communicates with a pneumatic circuit of a negative pressure generation device. The negative pressure generation device generates negative pressure in the pneumatic circuit, making it possible for the suction collet 211 to hold the electronic component W on the suction surface 211a. Further, the negative pressure generation device releases a suction force from the negative pressure by vacuum breakage or atmospheric release, thereby causing the suction collet 211 to release the electronic component W held on the suction surface 211a.

The fixing member 213 is a member for fixing the suction collet 211 to the upper surface 221a of the table 221 of the rotary conveying table 220. The suction collet 211 is provided on a surface of the fixing member 213 opposite to a surface in contact with the upper surface 221a of the table 221. An internal passage communicating with the suction hole of the suction collet 211 is formed in an interior of the fixing member 213.

The rotary conveying table 220 moves the suction holding parts 210 along the circular path C0 about the rotation axis A0. As illustrated in FIG. 3, the rotary conveying table 220 includes the table 221 provided with the suction holding parts 210, and a rotational drive part 223 that rotates the table 221 about the rotation axis A0. The upper surface 221a of the table 221 is a flat surface and is orthogonal to the rotation axis A0. The rotational drive part 223 is, for example, a motor, and rotates the table 221 about the rotation axis A0 together with the rotation axis A0. The rotational drive part 223 intermittently moves the table 221 by the installation interval of the suction holding parts 210. A rotation angle at which the table 221 intermittently moves is defined as a rotational pitch of the rotary conveying table 220.

The translational drive part 230 moves the rotary conveying table 220 translationally within the XY plane. As illustrated in FIG. 3, the translational drive part 230 includes a base 231 on which the rotary conveying table 220 is placed, a first drive mechanism 233 that moves the base 231 in the X direction, and a second drive mechanism 235 that moves the base 231 in the Y direction.

The rotational drive part 223 of the rotary conveying table 220 is fixed to the base 231. The first drive mechanism 233 includes a pair of guides 233a fixed on an installation table B on which the position correction section 20 is installed and parallel in the X direction, slide parts 233b that move in the X direction along the guides 233a, and a top plate 233c that is fixed on the slide parts 233b and moves in the X direction together with the slide parts 233b. The second drive mechanism 235 includes a pair of guides 235a fixed on the top plate 233c of the first drive mechanism 233 and parallel in the Y direction, and slide parts 235b that move in the Y direction along the guides 235a. The base 231 is fixed to the slide parts 235b of the second drive mechanism 235. The first drive mechanism 233 and the second drive mechanism 235 may be configured as electric actuators that move the slide parts 233b and 235b by motors (not illustrated), respectively.

The translational drive part 230 moves the rotary conveying table 220 placed on the base 231 translationally within the XY plane by the first drive mechanism 233 and the second drive mechanism 235. Thus, a planar position of the electronic component W suction-held by the suction holding part 210 of the rotary conveying table 220 is adjusted.

Further, the position correction section 20 may include an imaging part 250 that captures an image for checking the position of the conveyed electronic component W. The imaging part 250 is installed above the conveyance path of the electronic components W between the first transfer position Q1 and the second transfer position Q2, as illustrated in the upper portion of FIG. 1 and in FIG. 3, for example. The imaging part 250 may be, for example, a camera including an imaging element such as a charge coupled device (CCD) image sensor or a complementary metal oxide semiconductor (CMOS) image sensor. The image captured by the imaging part 250 is output to a control unit 70 that controls the conveying device 1. The control unit 70 controls the translational drive part 230 on the basis of the image captured by the imaging part 250 to adjust the planar position of the electronic component W, for example.

The conveying device 1 illustrated in FIG. 1 first suction-holds the electronic components W adhered to, for example, a wafer sheet S one by one by the first rotary conveying section 11, and conveys the electronic components W to the position correction section 20. The first rotary conveying section 11 rotates the rotating body 101 in one direction (counterclockwise in a side view as illustrated in the lower portion of FIG. 1, for example), and suction-holds one electronic component W from the wafer sheet S by the first holding part 110 at a pickup position Q0.

For example, at the pickup position Q0, an ejection device 30 is installed on a side of the wafer sheet S opposite to that of the first rotary conveying section 11, and ejects the electronic components W affixed to the wafer sheet S toward the first rotary conveying section 11 side. The ejection device 30 includes a pin 35 that ejects the electronic component W from a back surface of the wafer sheet S, and a motor (not illustrated) that moves the pin 35 in an ejection direction. The ejection direction is a direction orthogonal to the suction surface 111a of the first holding part 110 at the pickup position Q0. Note that the wafer sheet S is also set so as to be orthogonal to the ejection direction. In the conveying device 1 illustrated in FIG. 1, the ejection direction is the horizontal direction (X direction).

The ejection device 30 operates the pin 35 so as to eject the electronic component W to be conveyed from the back surface side of the wafer sheet S toward the first holding part 110 of the first rotary conveying section 11 in accordance with a timing at which the first holding part 110 is located at the pickup position Q0. The first holding part 110 suction-holds the ejected electronic component W on the suction surface 111a. The suction surface 111a of the first holding part 110 at the pickup position Q0 and the wafer sheet S are made parallel to each other, and the electronic component W is ejected by the pin 35 from a direction orthogonal thereto, making it possible to cause the electronic component W to be suctioned on the suction surface 111a of the first holding part 110.

The first holding part 110 holding the electronic component W moves within a vertical plane along the circular path C1 by the rotation of the rotating body 101. The first holding part 110 holding the electronic component W transfers the electronic component W with the suction holding part 210 of the position correction section 20 at the first transfer position Q1. At the first transfer position Q1, the suction surface 111a of the first holding part 110 and the suction surface 211a of the position correction section 20 are parallel to each other. Accordingly, the suction surface 211a of the position correction section 20 can hold the electronic component W received from the first holding part 110 in a correct posture without tilting.

The electronic component W adhered to the wafer sheet S is, at the flat surface thereof on the side opposite to the bump (electrode), in contact with the wafer sheet S. Therefore, the first holding part 110 suction-holds the surface on the bump side on the suction surface 111a, and the surface on the side opposite to the bump faces the outside. Accordingly, when the first holding part 110 and the suction holding part 210 of the position correction section 20 transfer the electronic component W at the first transfer position Q1, the suction holding part 210 suction-holds the flat surface of the electronic component W on the side opposite to the bump. Therefore, even in a case in which a size of the electronic component is small, the bump of the electronic component does not enter the suction hole in the suction surface 211a, and the posture of the electronic component W is rectified when the electronic component W is held on the suction surface 211a of the suction holding part 210. Even if the bump enters the suction hole and the electronic component W tilts when the suction surface 111a of the first holding part 110 suction-holds the electronic component W at the pickup position Q0, the suction holding part 210 holds the flat surface of the electronic component W on the side opposite to the bump on the suction surface 211a at the first transfer position Q1, rectifying the tilt that occurred.

Thus, the electronic component W suction-held on the suction surface 211a of the suction holding part 210 is in a proper posture without a tilt. The posture of the electronic component W is rectified at the first transfer position Q1 and thus, as long as the suction surface 211a of the suction holding part 210 and the suction surface of the second holding part 120 are parallel to each other at the second transfer position Q2, the electronic component W can be transferred therebetween in a state in which the electronic component W is held in a correct posture.

The suction holding part 210 that suction-holds the electronic component W moves from the first transfer position Q1 to the second transfer position Q2 within the horizontal plane along the circular path C0 by the rotation of the table 221. The suction holding part 210 holding the electronic component W transfers the electronic component W with the second holding part 120 of the second rotary conveying section 12 at the second transfer position Q2. At the second transfer position Q2, the suction surface of the second holding part 120 and the suction surface 211a of the position correction section 20 are parallel to each other. This makes it possible for the suction surface of the second holding part 120 to suction-hold the electronic component W in a correct posture from the suction surface 211a of the position correction section 20 without tilting.

The second holding part 120 holding the electronic component W moves within a vertical plane along the circular path C2 by the rotation of the rotating body 102. The second holding part 120 holding the electronic component W conveys the electronic component W to a processing device that performs the next process, and passes the electronic component W to the processing device. For example, as illustrated in FIG. 1, the second rotary conveying section 12 may further pass the electronic component W to a third rotary conveying section 13, and then the third rotary conveying section 13 may convey the electronic component W to a taping unit 50 that accommodates carrier tape (not illustrated).

The third rotary conveying section 13 is arranged in parallel in the X direction together with the first rotary conveying section 11 and the second rotary conveying section 12 as illustrated in the upper portion of FIG. 1, and rotates about a rotation axis A3 parallel to the Y direction as illustrated in the lower portion of FIG. 1. The third rotary conveying section 13 may be configured similarly to the first rotary conveying section 11 and the second rotary conveying section 12.

That is, as illustrated in the lower portion of FIG. 1, the third rotary conveying section 13 includes a rotating body 103 that rotates about the rotation axis A3 parallel to the Y direction together with the rotation axis A3, and a plurality of third holding parts 130 provided radially from the rotating body 103 in the ZX plane orthogonal to the Y direction. The plurality of third holding parts 130 are provided on the rotating body 103 at predetermined intervals in a circumferential direction of an imaginary circle about the rotation axis A3. The third holding parts 130 are configured similarly to the first holding parts 110 illustrated in FIG. 2, and each includes a suction collet and an advancing/retracting drive mechanism. The third holding part 130 moves the suction collet provided at a tip end in the advancing/retracting direction by the advancing/retracting movement mechanism.

As illustrated in the lower portion of FIG. 1, the third rotary conveying section 13 transfers the electronic component W with the second rotary conveying section 12 at a third transfer position Q3 where the second holding part 120 and the third holding part 130 correspond in the X direction. At the third transfer position Q3, the suction surface of the second holding part 120 and a suction surface of the third holding part 130 are parallel to each other. When the second holding part 120 suction-holding the electronic component W is located at the third transfer position Q3, the second holding part 120 is moved outward, bringing the electronic component W close to the suction surface of the third holding part 130. The third holding part 130 suction-holds, on the suction surface, the electronic component W brought close thereto, and receives the electronic component W from the second holding part 120.

The third holding part 130 holding the electronic component W moves within a vertical plane along a circular path C3 by the rotation of the rotating body 103, from the third transfer position Q3 to a supply position Q4 for supplying the electronic component W to the taping unit 50. The taping unit 50 is installed below the third rotary conveying section 13, for example, and the suction surface of the third holding part 130 and the taping unit 50 face each other in the vertical direction (Z direction) at the supply position Q4. The third holding part 130 holding the electronic component W, when located at the supply position Q4, releases the suction-held electronic component W. The released electronic component W is accommodated in a pocket (not illustrated) of the carrier tape in the taping unit 50.

This concludes the description of the configuration of the conveying device 1.

### 2. Operation

The conveying device 1 conveys the electronic component W to be conveyed by making the operation of the first rotary conveying section 11, the operation of the second rotary conveying section 12, and the operation of the position correction section 20 coincide in timing. In the conveying device 1 according to the present embodiment, the position correction section 20 that corrects the planar position of the electronic component W is provided between the first rotary conveying section 11 and the second rotary conveying section 12 on the conveyance path of the electronic component W, and thus alignment processing of the electronic component W is performed during the conveying process of the electronic component W. This shortens the time required for the alignment processing of the electronic component W. Hereinafter, the operation of the conveying device 1 will be described.

### 2-1. Operation Pattern 1

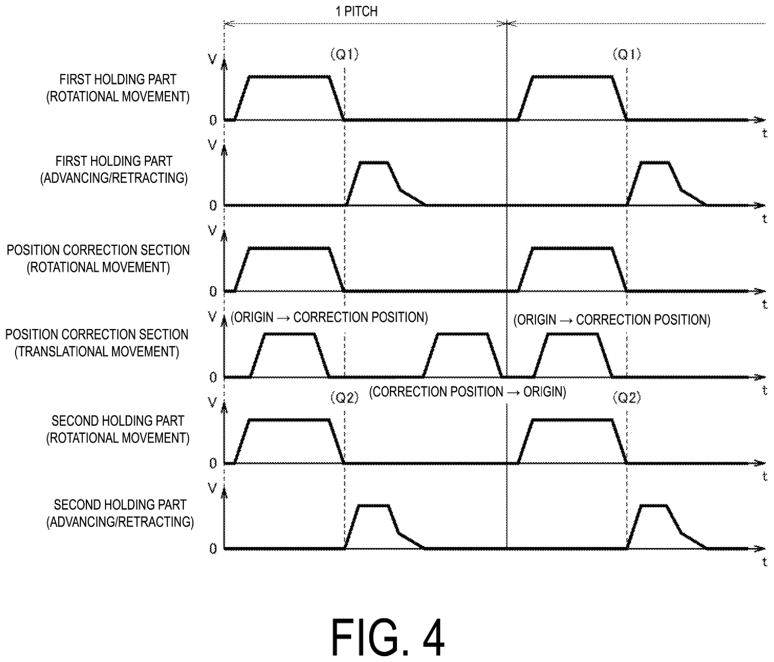

First, as an example of an operation pattern of the conveying device 1, a case (operation pattern 1) in which the transfer of the electronic component W at the first transfer position Q1 and the transfer of the electronic component W at the second transfer position Q2 are performed at the same timing will be described with reference to FIG. 4. FIG. 4 is a timing chart illustrating the operation of the conveying device 1 in the operation pattern 1.

FIG. 4 illustrates, as the operation of the first rotary conveying section 11, a rotational movement operation of moving along the circular path C1 and an advancing/retracting operation and illustrates, as the operation of the second rotary conveying section 12, a rotational movement operation of moving along the circular path C2 and an advancing/retracting operation. Further, FIG. 4 illustrates, as the operation of the position correction section 20, a rotational movement operation of moving the suction holding parts 210 along the circular path C0 and a translational movement operation of the translational drive part 230. In FIG. 4, a horizontal axis represents time t, and a vertical axis represents operation velocity V. The operation velocity V being 0 indicates that the operation is stopped, and the operation velocity V being greater than 0 indicates that the operation is underway. Note that the translational movement operation of the position correction section 20 is represented by the position correction operation in the X direction and the position correction operation in the Y direction collectively.

In the operation pattern 1, the conveying device 1 operates by synchronizing the rotational pitch of the first rotary conveying section 11, the rotational pitch of the second rotary conveying section 12, and the rotational pitch of the rotary conveying table 220 of the position correction section 20.

As illustrated in FIG. 4, when the first rotary conveying section 11 rotationally moves the rotating body 101 to move the first holding part 110 by one pitch, the rotary conveying table 220 of the position correction section 20 is moved by one pitch and the second holding part 120 of the second rotary conveying section 12 is also moved by one pitch at the same timing. At this time, the translational movement operation of the position correction section 20 is performed during the period from the start to the stop of the rotational movement operation of the position correction section 20.

In this translational movement operation, the planar position of the electronic component W to be transferred from the suction holding part 210 of the position correction section 20 to the second holding part 120 is corrected at the second transfer position Q2. Correction amounts in the X direction and the Y direction of the electronic component W from an origin position can be obtained by, for example, comparing a position of the electronic component W in the image captured by the imaging part 250 with a position at which the electronic component W would appear if there were no deviation from the origin position. The control unit 70 calculates the correction amounts in the X direction and the Y direction from the origin position of the electronic component W, and moves the rotary conveying table 220 translationally during the period from the start to the stop of the rotational movement operation of the rotary conveying table 220 by the position correction section 20, thereby correcting the planar position of the electronic component W at the second transfer position Q2.

When the rotational movement operation of the first rotary conveying section 11, the rotational movement operation of the second rotary conveying section 12, the rotational movement operation of the position correction section 20, and the translational movement operation of the position correction section 20 are completed, the electronic components W are transferred at the first transfer position Q1 and the second transfer position Q2.

In the advancing/retracting operation at the first transfer position Q1, first, the suction collet 111 of the first holding part 110 suction-holding the electronic component W is brought close to the suction holding part 210 of the position correction section 20, and the electronic component W is suction-held by the suction collet 211 of the suction holding part 210. Subsequently, the suction collet 111 releases the electronic component W from the suction-hold and is retracted to the original position. Similarly, in the advancing/retracting operation at the second transfer position Q2, first, the suction collet of the second holding part 120 is brought close to the suction holding part 210 of the position correction section 20, and the suction collet of the second holding part 120 suction-holds the electronic component W that is held by the suction holding part 210 and whose planar position has been corrected by the translational movement operation of the position correction section 20. Subsequently, the suction holding part 210 releases the electronic component W, and the second holding part 120, which suction-holds the electronic component W with the suction collet, is retracted to the original position.

When the advancing/retracting operation of the first holding part 110 and the advancing/retracting operation of the second holding part 120 are completed, the position correction section 20 performs the translational movement operation. In this translational movement operation, the rotary conveying table 220, which has been moved to correct the planar position of the electronic component W passed to the second holding part 120 at the second transfer position Q2, is moved to the origin position. Thus, the rotary conveying table 220 is positioned at the initial position for correcting the planar position of the electronic component W to be transferred next between the suction holding part 210 and the second holding part 120 at the second transfer position Q2. When such a translational movement operation is completed, the operation of one pitch is completed.

Thus, by correcting the planar position of the electronic component W within the rotational pitch of the rotary conveying table 220 of the position correction section 20, it is possible to efficiently implement the alignment processing of the electronic component W.

### 2-2. Operation Pattern 2

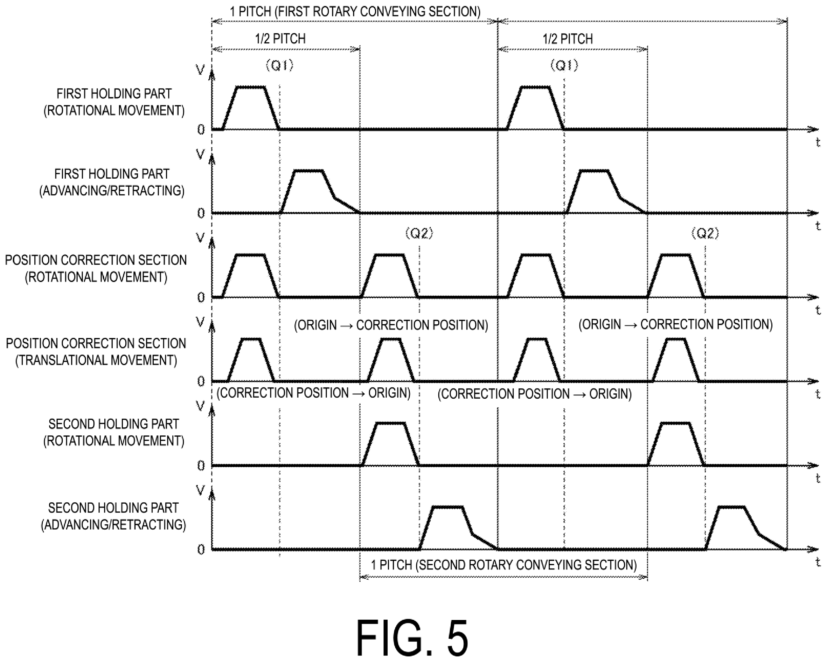

Next, as an example of the operation pattern of the conveying device 1, a case (operation pattern 2) in which the transfer of the electronic component W at the first transfer position Q1 and the transfer of the electronic component W at the second transfer position Q2 are performed at different timings will be described with reference to FIG. 5. FIG. 5 is a timing chart illustrating operation of the conveying device 1 in the operation pattern 2.

FIG. 5, similarly to FIG. 4, illustrates, as the operation of the first rotary conveying section 11, the rotational movement operation of moving along the circular path C1 and the advancing/retracting operation and illustrates, as the operation of the second rotary conveying section 12, the rotational movement operation of moving along the circular path C2 and the advancing/retracting operation. Further, FIG. 5 illustrates, as the operation of the position correction section 20, the rotational movement operation of moving the suction holding parts 210 along the circular path C0 and the translational movement operation by the translational drive part 230.

In the operation pattern 2, the conveying device 1 shifts the rotational pitch of the first rotary conveying section 11 and the rotational pitch of the second rotary conveying section 12 by one-half pitch, shifting the timing of the transfer of the electronic component W at the first transfer position Q1 and the timing of the transfer of the electronic component W at the second transfer position Q2. The rotary conveying table 220 of the position correction section 20 operates in synchronization with the rotational movement operation of the first rotary conveying section 11 and the rotational movement operation of the second rotary conveying section 12.

As illustrated in FIG. 5, when the first rotary conveying section 11 rotationally moves the rotating body 101 to move the first holding part 110 by one pitch, the rotary conveying table 220 of the position correction section 20 is moved by one pitch at the same timing. At this time, the translational movement operation of the position correction section 20 is performed during the period from the start to the stop of the rotational movement operation of the position correction section 20. In this translational movement operation, the rotary conveying table 220, which has been moved to correct the planar position of the electronic component W passed to the second holding part 120 at the second transfer position Q2 at the previous timing, is moved to the origin position. Thus, the rotary conveying table 220 is positioned at the initial position for correcting the planar position of the electronic component W to be transferred next between the suction holding part 210 and the second holding part 120 at the second transfer position Q2. The position correction section 20 translationally moves and positions the rotary conveying table 220 at the origin position during the period from the start to the stop of the rotational movement operation of the rotary conveying table 220.

When the rotational movement operation of the first rotary conveying section 11, the rotational movement operation of the position correction section 20, and the translational movement operation of the position correction section 20 are completed, the electronic component W is transferred at the first transfer position Q1. In the advancing/retracting operation at the first transfer position Q1, similarly to the operation pattern 1, first, the suction collet 111 of the first holding part 110 suction-holding the electronic component W is brought close to the suction holding part 210 of the position correction section 20, and the electronic component W is suction-held by the suction collet 211 of the suction holding part 210. Subsequently, the suction collet 111 releases the electronic component W from the suction-hold and is retracted to the original position.

When the advancing/retracting operation of the first holding part 110 is completed, the second rotary conveying section 12 rotationally moves the rotating body 102 to move the second holding part 120 by one pitch. At the same timing as the rotational movement operation of the second rotary conveying section 12, the rotary conveying table 220 of the position correction section 20 is moved by one pitch. At this time, the translational movement operation of the position correction section 20 is performed during the period from the start to the stop of the rotational movement operation of the position correction section 20. In this translational movement operation, the planar position of the electronic component W to be transferred from the suction holding part 210 of the position correction section 20 to the second holding part 120 is corrected at the second transfer position Q2. In such a translational movement operation, similarly to the operation pattern 1, the control unit 70 uses the image captured by the imaging part 250 to calculate the correction amounts in the X direction and the Y direction from the origin position of the electronic component W, and moves the rotary conveying table 220 translationally during the period from the start to the stop of the rotational movement operation of the rotary conveying table 220 by the position correction section 20, thereby correcting the planar position of the electronic component W at the second transfer position Q2.

When the rotational movement operation of the second rotary conveying section 12, the rotational movement operation of the position correction section 20, and the translational movement operation of the position correction section 20 are completed, the electronic component W is transferred at the second transfer position Q2. In the advancing/retracting operation at the second transfer position Q2, similarly to the operation pattern 1, first, the suction collet of the second holding part 120 is brought close to the suction holding part 210 of the position correction section 20, and the suction collet of the second holding part 120 suction-holds the electronic component W that is held by the suction holding part 210 and whose planar position has been corrected by the translational movement operation of the position correction section 20. Subsequently, the suction holding part 210 releases its suction hold on the electronic component W, and the second holding part 120, which suction-holds the electronic component W with the suction collet, is retracted to the original position.

When the advancing/retracting operation of the second holding part 120 is completed, the transfer of the electronic component W at the first transfer position Q1 and the transfer of the electronic component W at the second transfer position Q2 are completed once each. In the operation pattern 2, the above operation is repeated.

Thus, in the operation pattern 2 as well, by correcting the planar position of the electronic component W within the rotational pitch of the rotary conveying table 220 of the position correction section 20, it is possible to efficiently implement the alignment processing of the electronic component W. In the operation pattern 2, the timing of the transfer of the electronic component W at the first transfer position Q1 and the timing of the transfer of the electronic component W at the second transfer position Q2 are shifted from each other, and thus the translational movement operation of translationally moving and positioning the rotary conveying table 220 at the origin position is performed during the rotational movement of the first rotary conveying section 11. This makes it possible to efficiently perform the translational movement operation of the position correction section 20, and accelerate the conveying of the electronic component W by the conveying device 1.

### 3. Modifications

### 3-1. Change in Arrangement of Constituent Elements

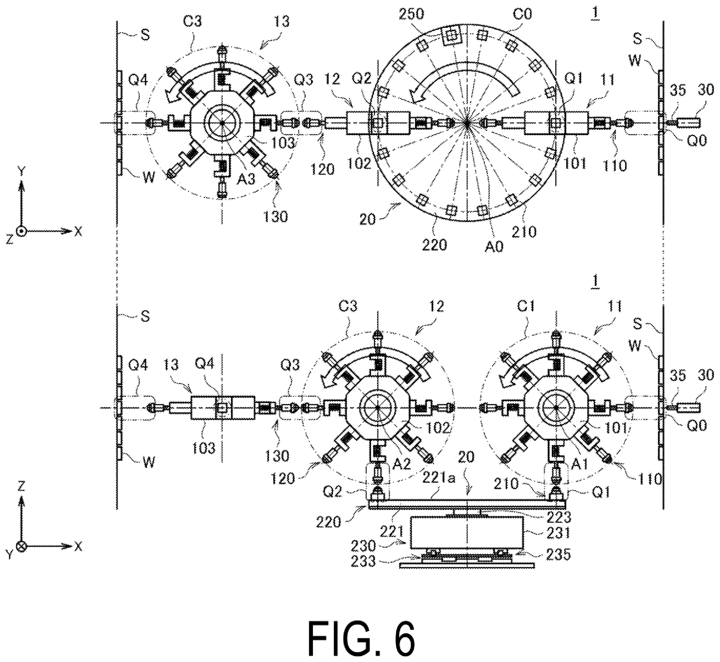

In the conveying device 1 according to the present invention, the arrangement of each constituent element of the conveying device 1 including the first rotary conveying section 11, the second rotary conveying section 12, and the position correction section 20 is not limited to the configuration illustrated in FIG. 1. For example, the conveying device 1 may be configured as illustrated in FIG. 6 to FIG. 9.

### First Modification

The conveying device 1 illustrated in FIG. 6, as compared with the configuration of the conveying device 1 illustrated in FIG. 1, differs in the arrangement of the third rotary conveying section 13 in that the third rotary conveying section 13 is provided so that the rotation axis A3 extends in the Z direction. The third rotary conveying section 13 receives, by the third holding part 130, the electronic component W from the second holding part 120 holding the electronic component W at the third transfer position Q3, and conveys the electronic component W along the circular path C3. Then, the third holding part 130 accommodates the conveyed electronic component W in the wafer sheet S at the supply position Q4 facing the wafer sheet S on the accommodation side, for example. Thus, the conveying device 1 may be configured by changing an orientation of the arrangement of the third rotary conveying section 13.

### Second Modification

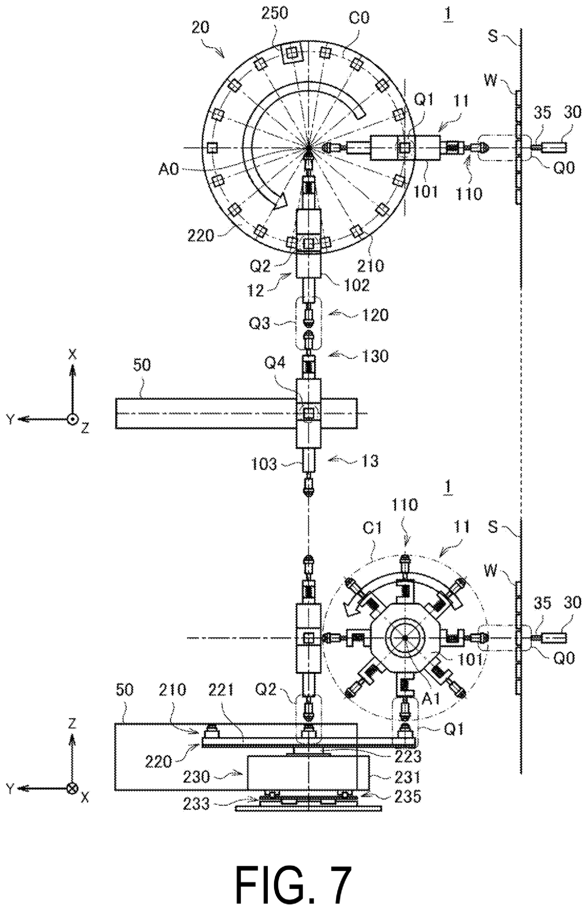

The conveying device 1 illustrated in FIG. 7, as compared with the configuration of the conveying device 1 illustrated in FIG. 1, differs in the arrangement of the first rotary conveying section 11 in that the first rotary conveying section 11 is arranged in a state of being rotated by 90° with respect to the rotation axis A0 of the position correction section 20. The rotation axis A1 of the first rotary conveying section 11 is parallel to the X direction. When the conveyance path of the electronic component W is viewed in the plan view of the conveying device 1 illustrated in FIG. 7, the electronic component W is moved in the Y direction by the first rotary conveying section 11, then moved 270° within the horizontal plane (XY plane) by the position correction section 20, and subsequently moved in the X direction by the second rotary conveying section 12. Thus, the positions of the first rotary conveying section 11 and the second rotary conveying section 12 with respect to the rotation axis A0 of the position correction section 20 are changed, thereby making it possible to change the conveying direction of the electronic component W.

In the conveying device 1 illustrated in FIG. 7, the first rotary conveying section 11 and the second rotary conveying section 12 are arranged at an angle of 90° in a plan view. Therefore, in a case in which the suction holding parts 210 are provided on the rotary conveying table 220 at the installation interval of 20°, the timing of the transfer of the electronic component W at the first transfer position Q1 and the timing of the transfer of the electronic component W at the second transfer position Q2 cannot be made to coincide. In such a case, the conveying device 1 is operated by shifting the timing of the transfer of the electronic component W at the first transfer position Q1 and the timing of the transfer of the electronic component W at the second transfer position Q2 as in the operation pattern 2 illustrated in FIG. 5.

### Third Modification

In the conveying device 1 illustrated in FIG. 1, the suction holding part 210 of the position correction section 20 is arranged such that the suction surface 211a is always parallel to the horizontal plane (XY plane). However, the suction surface 211a need only be parallel to the opposing suction surface of the second holding part 120 at the second transfer position Q2.

As described above, when the first holding part 110 and the suction holding part 210 of the position correction section 20 transfer the electronic component W at the first transfer position Q1, the suction holding part 210 suction-holds the surface of the electronic component W on the side opposite to the bump. At this time, the bump does not enter the suction hole in the suction surface 211a, and thus the electronic component W is rectified in posture when held on the suction surface 211a of the suction holding part 210. That is, the electronic component W suction-held on the suction surface 211a of the suction holding part is in a proper posture without tilting. Accordingly, as long as the suction surface 211a of the suction holding part 210 and the suction surface of the second holding part 120 are parallel to each other at the second transfer position Q2, it is possible to transfer the electronic component W therebetween while the electronic component W is held in the correct posture.

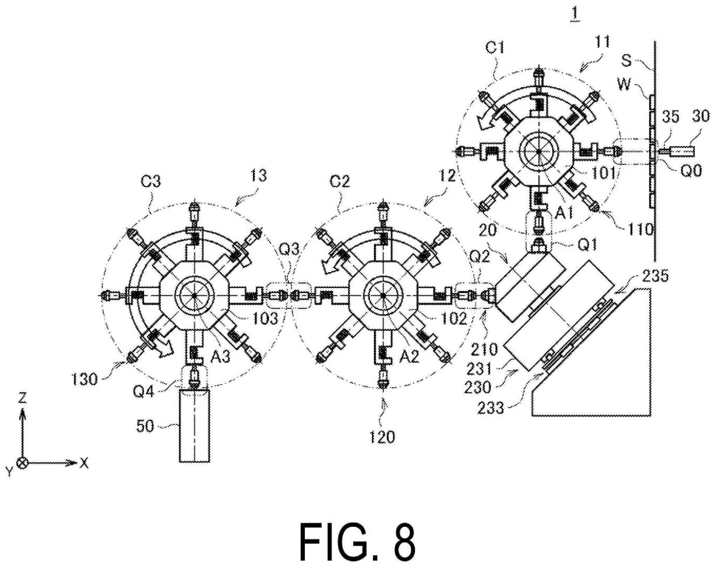

For example, as illustrated in FIG. 8, the position correction section 20 may be installed tilted at 45° with respect to the horizontal plane (XY plane) such that, at the first transfer position Q1, the suction surface 111a of the first holding part 110 and the suction surface 211a of the suction holding part 210 are parallel in the horizontal direction and, at the second transfer position Q2, the suction surface of the second holding part 120 and the suction surface 211a of the suction holding part 210 are parallel in the vertical direction. In this case, the posture of the electronic component W is rectified when the electronic component W is held on the suction surface 211a of the suction holding part 210 at the first transfer position Q1. Then, the electronic component W moved by the rotation of the rotary conveying table 220 is suction-held on the suction surface of the second holding part 120 at the second transfer position Q2. The suction surface of the second holding part 120 and the suction surface 211a of the suction holding part 210 are parallel to each other at the second transfer position Q2, making it possible to transfer the electronic component W while the electronic component W is held in the correct posture.

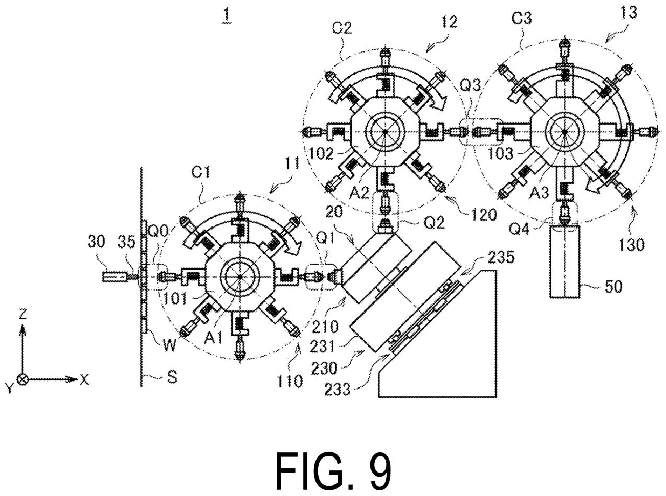

Further, for example, as illustrated in FIG. 9, the position correction section 20 may be installed tilted at 45° with respect to the horizontal plane (XY plane) such that, at the first transfer position Q1, the suction surface 111a of the first holding part 110 and the suction surface 211a of the suction holding part 210 are parallel in the vertical direction and, at the second transfer position Q2, the suction surface of the second holding part 120 and the suction surface 211a of the suction holding part 210 are parallel in the horizontal direction. In this case as well, the posture of the electronic component W is rectified when the electronic component W is held on the suction surface 211a of the suction holding part 210 at the first transfer position Q1. Then, the electronic component W moved by the rotation of the rotary conveying table 220 is suction-held on the suction surface of the second holding part 120 at the second transfer position Q2. The suction surface of the second holding part 120 and the suction surface 211a of the suction holding part 210 are parallel to each other at the second transfer position Q2, making it possible to transfer the electronic component W while the electronic component W is held in the correct posture.

### 3-2. Position Correction of Electronic Component in Rotary Conveying Section

Further, in the conveying device 1 according to the present invention, instead of provision of the position correction section 20, a function of correcting the position of the electronic component W may be provided in the second rotary conveying section 12 between the first rotary conveying section 11 and the third rotary conveying section 13. That is, the second rotary conveying section 12 is caused to function as the position correction section 20 in the embodiment described above.

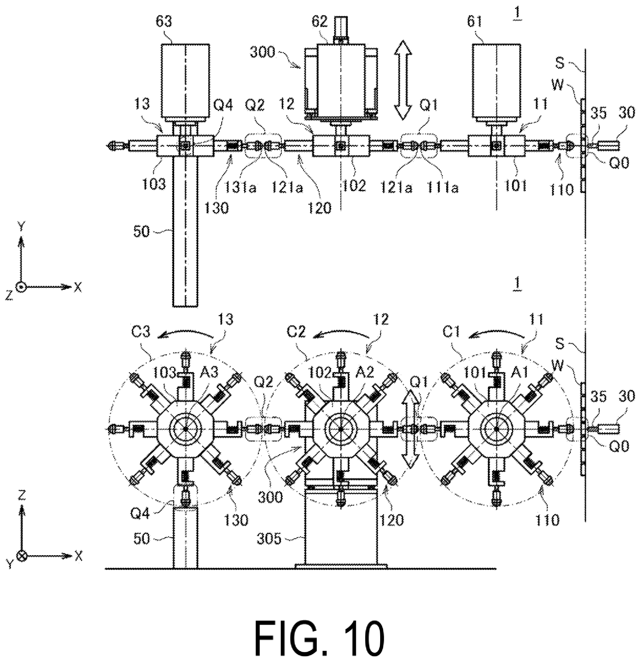

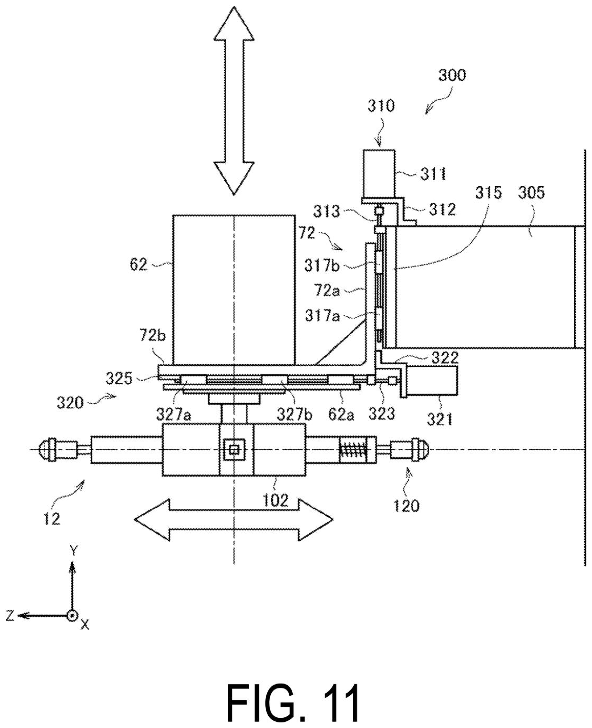

FIG. 10 and FIG. 11 illustrate, as a modification of the conveying device 1 according to the present invention, a configuration example of the conveying device 1 in a case in which a position correction mechanism 300 that corrects the position of the electronic component W is provided in the second rotary conveying section 12. In FIG. 10, the upper portion illustrates the conveying device 1 in a plan view, and the lower portion illustrates the conveying device 1 in a side view. FIG. 11 is a schematic view illustrating the second rotary conveying section 12 and the position correction mechanism 300, and illustrates the state illustrated in the upper portion of FIG. 10 as viewed from the X direction.

The conveying device 1 illustrated in FIG. 10 includes the first rotary conveying section 11, the second rotary conveying section 12, and the third rotary conveying section 13. The first rotary conveying section 11, the second rotary conveying section 12, and the third rotary conveying section 13 are arranged in parallel in the X direction as illustrated in the upper portion of FIG. 10, and rotate about the rotation axes A1, A2, and A3 of drive parts 61, 62, and 63 parallel to the Y direction as illustrated in the lower portion of FIG. 10. The configurations of the first rotary conveying section 11, the second rotary conveying section 12, and the third rotary conveying section 13 are similar to those of the conveying device 1 in FIG. 1.

The second rotary conveying section 12 in the present modification includes the position correction mechanism 300 in order to correct the position of the electronic component W received from the first holding part 110 of the first rotary conveying section 11 and transfer the electronic component W to the third holding part 130 of the third rotary conveying section 13. The position correction mechanism 300 is a mechanism that moves the second rotary conveying section 12 translationally. The translational movement of the second rotary conveying section 12 by the position correction mechanism 300 is performed within a plane parallel to the suction surface of the second holding part 120 at the first transfer position Q1 at which the electronic component W is transferred from the first holding part 110 to the second holding part 120 or at the second transfer position Q2 at which the electronic component W is transferred from the second holding part 120 to the third holding part 130.

For example, in the conveying device 1 illustrated in FIG. 10, the suction surface of the second holding part 120 is parallel to a YZ plane at the first transfer position Q1 and the second transfer position Q2. As a result, the position correction mechanism 300 illustrated in FIG. 11 includes a first drive part 310 that moves the second rotary conveying section 12 in the Y direction that is a direction parallel to the rotation axis, and a second drive part 320 that moves the second rotary conveying section 12 in the Z direction that is a direction orthogonal to the rotation axis.

Note that the second rotary conveying section 12 is attached to a support base 305 on which the second rotary conveying section 12 is installed, via a motor support plate 62a, a bracket 72, and the position correction mechanism 300. The motor support plate 62a is fixed to the drive part 62 such as a motor that rotates the rotating body 102, and moves translationally within the YZ plane together with the second rotary conveying section 12. The bracket 72 is an L-shaped member composed of a first surface 72a parallel to the XY plane and a second surface 72b parallel to the ZX plane. The bracket 72 moves in the Y direction together with the second rotary conveying section 12.

The first drive part 310 is fixed to the support base 305. The first drive part 310 includes a motor 311, a ball screw 313, a pair of guides 315, and slide parts 317a and 317b. The motor 311 is fixed to the support base 305 by using a motor bracket 312. The ball screw 313 converts a rotational motion of the motor 311 into a linear motion. The pair of guides 315 are fixed on the support base 305 in a parallel state in the Y direction. The slide parts 317a and 317b move in the Y direction along the pair of guides 315 by the linear motion of the ball screw 313.

The first surface 72a of the bracket 72 is fixed to the slide parts 317a and 317b. Accordingly, the bracket 72 moves in the Y direction together with the slide parts 317a and 317b. As the bracket 72 moves in the Y direction, the second rotary conveying section 12, which is supported on the bracket 72 with the motor support plate 62a and the second drive part 320 described below interposed therebetween, also moves in the Y direction.

The second drive part 320 is fixed to the bracket 72. The second drive part 320 includes a motor 321, a ball screw 323, a pair of guides 325, and slide parts 327a and 327b. The motor 321 is fixed to the first surface 72a of the bracket 72 by using a motor bracket 322. The ball screw 323 converts a rotational motion of the motor 321 into a linear motion. The pair of guides 325 are fixed to the second surface 72b of the bracket 72 in a parallel state in the Z direction. The slide parts 327a and 327b move in the Z direction along the pair of guides 325 by the linear motion of the ball screw 323.

The motor support plate 62a is fixed to the slide parts 327a and 327b, and moves in the Z direction together with the slide parts 327a and 327b. Here, a through-hole having a size that allows the drive part 62 to be inserted therethrough is provided in the second surface 72b of the bracket 72, and the drive part 62 is not directly fixed to the bracket 72. Accordingly, the motor support plate 62a can move in the Z direction relative to the bracket 72 together with the slide parts 327a and 327b. As the motor support plate 62a moves in the Z direction, the second rotary conveying section 12 fixed to the motor support plate 62a also moves in the Z direction.

The position correction mechanism 300 moves the second rotary conveying section 12 translationally within the YZ plane by the first drive part 310 and the second drive part 320. Accordingly, the planar position of the electronic component W suction-held by the second holding part 120 of the second drive part 320 is adjusted. Note that the second rotary conveying section 12 may be provided with an imaging part (not illustrated) that captures an image for checking the position of the electronic component W to be conveyed in the conveyance path of the electronic component W between the first transfer position Q1 and the second transfer position Q2. Accordingly, for example, a control unit (not illustrated) that controls the conveying device 1 can adjust the planar position of the electronic component W by controlling the position correction mechanism 300 on the basis of the image captured by the imaging part.

The conveying device 1 illustrated in FIG. 10 first suction-holds the electronic components W adhered to the wafer sheet S, for example, one by one by the first rotary conveying section 11, and transfers the electronic components W to the second rotary conveying section 12. The first rotary conveying section 11 rotates the rotating body 101 in one direction (counterclockwise in a side view as illustrated in the lower portion of FIG. 10, for example), and suction-holds one electronic component W from the wafer sheet S by the first holding part 110 at the pickup position Q0. The pickup of the electronic component W may, as in the conveying device 1 illustrated in FIG. 1, be performed by, for example, ejecting the electronic component W affixed to the wafer sheet S toward the first rotary conveying section 11 side by the ejection device 30, and suctioning the electronic component W on the suction surface 111a of the first holding part 110. In the conveying device 1 illustrated in FIG. 10, the ejection direction is the horizontal direction (X direction).

The first holding part 110 holding the electronic component W moves within a vertical plane along the circular path C1 by the rotation of the rotating body 101. The first holding part 110 holding the electronic component W transfers the electronic component W with the second holding part 120 of the second rotary conveying section 12 at the first transfer position Q1. At the first transfer position Q1, the suction surface 111a of the first holding part 110 and the suction surface 121a of the second holding part 120 are parallel to each other. Accordingly, the suction surface 121a of the second holding part 120 can hold the electronic component W received from the first holding part 110 in a correct posture without tilting.

The electronic component W adhered to the wafer sheet S is, at the flat surface thereof on the side opposite to the bump (electrode), in contact with the wafer sheet S. Therefore, the first holding part 110 suction-holds the surface on the bump side on the suction surface 111a, and the surface on the side opposite to the bump faces the outside. Accordingly, when the first holding part 110 and the second holding part 120 transfer the electronic component W at the first transfer position Q1, the second holding part 120 suction-holds the flat surface of the electronic component W on the side opposite to the bump. Therefore, even in a case in which the size of the electronic component is small, the bump of the electronic component does not enter the suction hole in the suction surface 121a, and the electronic component W is rectified in posture when held on the suction surface 121a of the second holding part 120. Even if the bump enters the suction hole and the electronic component W tilts when the suction surface 111a of the first holding part 110 suction-holds the electronic component W at the pickup position Q0, the second holding part 120 holds the flat surface of the electronic component W on the side opposite to the bump on the suction surface 121a at the first transfer position Q1, rectifying the tilt that occurred.

Thus, the electronic component W suction-held on the suction surface 121a of the second holding part 120 is in a proper posture without a tilt. The posture of the electronic component W is rectified at the first transfer position Q1 and thus, as long as the suction surface 121a of the second holding part 120 and the suction surface 131a of the third holding part 130 are parallel to each other at the second transfer position Q2, the electronic component W can be transferred therebetween in a state in which the electronic component W is held in a correct posture.

The second holding part 120 holding the electronic component W moves from the first transfer position Q1 to the second transfer position Q2 within the vertical plane along the circular path C2 by the rotation of the rotating body 102. The second rotary conveying section 12 is moved by the position correction mechanism 300 translationally during the movement of the second holding part 120, correcting the planar position of the electronic component W suction-held by the second holding part 120. Then, the second holding part 120 holding the electronic component W transfers the electronic component W with the third holding part 130 of the third rotary conveying section 13 at the second transfer position Q2.

At the second transfer position Q2, the suction surface 121a of the second holding part 120 and the suction surface 131a of the third holding part 130 are parallel to each other. This makes it possible for the suction surface 131a of the third holding part 130 to suction-hold the electronic component W from the suction surface 121a of the second holding part 120 in a correct posture without tilting. The third rotary conveying section 13 conveys the electronic component W to the taping unit 50 that accommodates the carrier tape (not illustrated), for example, and releases the electronic component W suction-held at the supply position Q4.

In the conveying device 1 illustrated in FIG. 10 and FIG. 11, the second rotary conveying section 12 is made to function as the position correction section 20 in the embodiment described above, and the planar position of the suction-held electronic component W is corrected by the position correction mechanism 300 in the second rotary conveying section 12. With such a conveying device 1, similarly to the conveying device 1 of the embodiment described above, the posture of the electronic component W is rectified when the electronic component W is held on the suction surface 121a of the second holding part 120 at the first transfer position Q1. Then, the electronic component W moved by the rotation of the rotating body 102 of the second rotary conveying section 12 is suction-held on the suction surface 131a of the third holding part 130 at the second transfer position Q2. The suction surface 121a of the second holding part 120 and the suction surface 131a of the third holding part 130 are parallel to each other at the second transfer position Q2, making it possible to transfer the electronic component W in a state in which the electronic component W is held in a correct posture.

### 4. Conclusion

The configuration and the operation of the conveying device 1 according to the embodiment of the present invention have been described above. The conveying device 1 according to the present embodiment includes, between the first rotary conveying section 11 and the second rotary conveying section 12 on the conveyance path of the electronic component W, the position correction section 20 that corrects the position of the electronic component W received from the first holding part 110 and transfers the electronic component W to the second holding part 120. The position correction section 20 moves the rotary conveying table 220 translationally by the translational drive part 230 during the rotation of the rotary conveying table 220, and corrects the planar position of the electronic component W suction-held by the suction holding part 210. This makes it possible to efficiently implement the alignment processing of the electronic component W. Further, the suction surface 211a of the suction holding part 210 and the suction surface of the second holding part 120 facing each other at the second transfer position Q2 are made parallel to each other. This makes it possible to transfer the electronic component W in a state of the electronic component W being in a correct posture obtained by rectification when the suction holding part 210 suctioned the electronic component W at the first transfer position Q1.

In the foregoing description, preferred embodiments of the present invention have been set forth in detail with reference to the accompanying drawings, but the present invention is not limited to such examples. It will be apparent to those having general knowledge in the technical field to which the present invention belongs that various alternations and modifications can be made within the scope of the technical ideas described in the appended claims. These will also naturally be understood as falling under the technical scope of the present invention.

For example, in the embodiment described above, the conveying device corrects the planar position of the electronic component conveyed, but the present invention is not limited to such an example. For example, in addition to correction of the planar position of the electronic component conveyed, the conveying device may perform rotation correction. The rotation correction of the electronic component can be performed by rotating, about an axis perpendicular to the suction surface, the suction collet that suction-holds the electronic component. The rotation correction of the electronic component is performed by any one of the first rotary conveying section, the second rotary conveying section, or the position correction section.

### Reference Signs List

1: Conveying device, 11: First rotary conveying section, 12: Second rotary conveying section, 13: Third rotary conveying section, 20: Position correction section, 30: Ejection device, 35: Pin, 50: Taping unit, 70: Control unit, 101, 102, 103: Rotating body, 110: First holding part, 111: Suction collet, 111a, 121a, 131a: Suction surface, 112: Advancing/retracting drive mechanism, 113: Shaft, 114: Connection member, 120: Second holding part, 130: Third holding part, 210: Suction holding part, 211: Suction collet, 211a: Suction surface, 213: Fixing member, 220: Rotary conveying table, 221: Table, 223: Rotational drive part, 230: Translational drive part, 231: Base, 233: First drive mechanism, 233a, 235a: Guide, 233b, 235b: Slide part, 233c: Top plate, 235: Second drive mechanism, 250: Imaging part, Q0: Pickup position, Q1: First transfer position, Q2: Second transfer position, Q3: Third transfer position, Q4: Supply position, S: Wafer sheet, W: Electronic component

## Claims

1. A conveying device comprising:
a first rotary conveying section including a first holding part configured to suction-hold an electronic component on a suction surface of the first holding part, the first rotary conveying section configured to move the first holding part along a circular path;
a second rotary conveying section including a second holding part configured to suction-hold the electronic component on a suction surface of the second holding part, the second rotary conveying section configured to move the second holding part along a circular path; and
a position correction section provided between the first rotary conveying section and the second rotary conveying section on a conveyance path of the electronic component, the position correction section configured to correct a position of the electronic component received from the first holding part and transfer the electronic component to the second holding part, wherein
the position correction section includes
a suction holding part that includes a suction surface configured to suction-hold the electronic component, transfers the electronic component with the first holding part at a first transfer position, and transfers the electronic component with the second holding part at a second transfer position,
a rotary conveying table that is provided with the suction holding part, and moves the suction holding part along a circular path about a rotation axis, and
a translational drive part that moves the rotary conveying table translationally, and corrects a planar position of the electronic component suction-held by the suction holding part, and
the suction surface of the suction holding part and the suction surface of the second holding part facing each other at the second transfer position are parallel to each other.

2. The conveying device according to claim 1, wherein
the rotary conveying table intermittently moves at a predetermined rotational pitch while stopping at the first transfer position and the second transfer position, and
the translational drive part moves the rotary conveying table translationally during rotation of the rotary conveying table to correct the planar position of the electronic component suction-held by the suction holding part.

3. The conveying device according to claim 2, wherein
a timing at which the electronic component is transferred from the first holding part to the suction holding part at the first transfer position coincides with a timing at which the electronic component is transferred from the suction holding part to the second holding part at the second transfer position.

4. The conveying device according to claim 2, wherein
a timing at which the electronic component is transferred from the first holding part to the suction holding part at the first transfer position is different from a timing at which the electronic component is transferred from the suction holding part to the second holding part at the second transfer position.
